# EUROPÄISCHE PATENTSCHRIFT

(11) **EP 3 562 282 B1**
(45) Veröffentlichungstag und Bekanntmachung des Hinweises auf die Patenterteilung: **07.07.2021**
(21) Anmeldenummer: 18169235.1
(22) Anmeldetag: 25.04.2018
(51) Int. Cl.: H05K 7/14

(54) **BACKPLANE**
BACKPLANE
FOND DE PANIER

(43) Veröffentlichungstag der Anmeldung: 30.10.2019
(73) Patentinhaber: Siemens Aktiengesellschaft, 80333 München (DE)
(72) Erfinder: SCHIFFEL, Andre, 09474 Crottendorf (DE)

(56) Entgegenhaltungen:
- EP-A1- 1 553 630
- WO-A1-93/15464
- DE-A1-102016 002 052
- US-A1- 2002 141 130
- US-B1- 7 464 459

## Beschreibung

Die Erfindung betrifft eine Backplane zum elektrischen Verbinden elektrischer Bauelemente. Ferner betrifft die Erfindung einen Schaltschrank.

Unter einer Backplane wird hier ein Träger für elektrische Bauelemente verstanden, der Leitungen zum elektrischen Verbinden elektrischer Bauelemente aufweist. Derartige elektrische Bauelemente sind beispielsweise Niederspannungsschaltgeräte wie Schütze, Motorschutzschalter, Motorstarter, Sanftstarter oder Relais, oder Steuerungseinheiten oder Eingabe-/ Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 (Liebherr-Components Biberach GmbH) 22.06.2017 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

WO 93/15464 A1 (Kelly, Ralph Harold [GB]) 5. August 1993 beschreibt eine Rückwandplatine 10 für einen Computer oder ein ähnliches System, welches einen Bus und mehrere Steckplätze hat. Um die Verbindbarkeit der Steckplätze in verschiedene Cluster steuern zu können, ist jeder Steckplatz durch ein Schalterarray mit variablem Zustand mit dem Bus verbunden. Das Schalterarray kann als ein 1-zu-2-Demultiplexer ausgestaltet sein, in Form einer integrierten Schaltung 26 mit Eingangsleitungen 34 des Busses und zwei Sätzen von Ausgangsleitungen 35, 36, die durch Schaltgruppen 37, 38 verbunden sind, deren Zustände durch eine von einem Steuerbus 40 gesteuerte Schaltschnittstelle 39 variabel sind.

Der Erfindung liegt die Aufgabe zugrunde, eine verbesserte Backplane und einen verbesserten Schaltschrank anzugeben.

Die Aufgabe wird erfindungsgemäß durch eine Backplane mit den Merkmalen des Anspruchs 1 und einen Schaltschrank mit den Merkmalen des Anspruchs 8 gelöst.

Vorteilhafte Ausgestaltungen der Erfindung sind Gegenstand der Unteransprüche.

Eine erfindungsgemäße Backplane zum elektrischen Verbinden elektrischer Bauelemente umfasst eine Trägerplatte, ein auf und/oder in der Trägerplatte angeordnetes elektrisches Leitungsnetz, das Netzknoten und jeweils zwei Netzknoten verbindende Verbindungsleitungen aufweist, und ansteuerbare Schaltungseinheiten zum steuerbaren Unterbrechen und Freischalten jeweils einer Verbindungsleitung.

Durch das Leitungsnetz und die Schaltungseinheiten können verschiedene durch das Leitungsnetz verlaufende Stromwege realisiert werden, indem Netzknoten durch Freischalten von Verbindungsleitungen mittels der Schaltungseinheiten elektrisch miteinander verbunden werden. Die Ansteuerbarkeit der Schaltungseinheiten ermöglicht insbesondere, Stromwege zeitweise oder dauerhaft entsprechend aktueller Anforderungen zu generieren, beispielsweise um elektrische Bauelemente zu- und abzuschalten, die nur kurzfristig benötigt werden, oder um elektrische Bauelemente applikationsbedingt unterschiedlich zu beschalten, z. B. um eine Drehrichtungsänderung beziehungsweise einen Reversierbetrieb eines Motors zu realisieren, oder nachträglich Änderungen des Stromlaufplans zu realisieren. So kann beispielsweise auf Änderungen des Stromlaufplans reagiert werden, die sonst eine aufwändige Umarbeitung der Backplane oder Realisierung der Änderungen mittels konventioneller Verdrahtungstechnik oder sogar eine Neuanfertigung der Backplane zur Folge haben könnten. Die flexible Schaltbarkeit des Leitungsnetzes durch die Schaltungseinheiten ermöglicht ferner eine zeitversetzte Mehrfachnutzung von Verbindungsleitungen des Leitungsnetzes für voneinander verschiedene Stromkreise, deren gleichzeitige Benutzung sich applikativ ausschließt. Dadurch können insbesondere die Anzahl der elektrischen Leitungen und somit der Materialaufwand und die Kosten für die Herstellung der Backplane gesenkt werden. Ferner können die Komplexität der elektrischen Verbindungen reduziert werden und deren Entflechtungsmöglichkeiten verbessert werden.

Eine Ausgestaltung der Erfindung sieht vor, dass wenigstens eine Schaltungseinheit als ein Mikrosystem ausgebildet ist. Eine weitere Ausgestaltung der Erfindung sieht vor, dass jede Schaltungseinheit als ein Mikrosystem ausgebildet ist. Unter einer als ein Mikrosystem, das auch als MEMS (Micro-Electro-Mechanical System) bezeichnet wird, ausgebildeten Schaltungseinheit wird eine miniaturisierte Schaltungseinheit verstanden. Mikrosysteme eignen sich vorteilhaft zur Realisierung der Schaltungseinheiten, da sie wenig Bauraum erfordern.

Eine weitere Ausgestaltung der Erfindung sieht vor, dass an oder in jeder Verbindungsleitung des Leitungsnetzes eine Schaltungseinheit angeordnet ist. Dies ermöglicht vorteilhaft, die Netzknoten des Leitungsnetzes in beliebiger Weise elektrisch miteinander zu verbinden, und realisiert dadurch eine optimale Flexibilität der Nutzung des Leitungsnetzes.

Eine weitere Ausgestaltung der Erfindung sieht vor, dass das Leitungsnetz Steuerleitungen zum Ansteuern der Schaltungseinheiten aufweist. Dies ermöglicht eine elektrische Ansteuerung der Schaltungseinheiten über die Steuerleitungen.

Erfindungsgemäß ist vorgesehen, dass die Schaltungseinheiten drahtlos, beispielsweise durch Funksignale wie Bluetooth-Signale oder WLAN (= Wireless Local Area Network)-Signale, ansteuerbar sind. Dadurch kann der Leitungsaufwand für die Ansteuerung der Schaltungseinheiten gesenkt werden und/oder die Ansteuerung der Schaltungseinheiten flexibilisiert werden.

Eine weitere Ausgestaltung der Erfindung sieht vor, dass die Backplane eine Steuereinheit zum Ansteuern der Schaltungseinheiten aufweist. Dadurch wird die Ansteuerung der Schaltungseinheiten durch eine in die Backplane integrierte Steuereinheit ermöglicht.

Ein erfindungsgemäßer Schaltschrank weist eine erfindungsgemäße Backplane auf.

Die Verwendung einer Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Die erfindungsgemäße Ausführung der Backplane mit einem Leitungsnetz und ansteuerbaren Schaltungseinheiten hat darüber hinaus die oben bereits genannten Vorteile, die sich aus der flexiblen Realisierbarkeit verschiedener Stromwege durch das Leitungsnetz ergeben.

Bei einem Verfahren zur Herstellung einer erfindungsgemäßen Backplane können die Trägerplatte, das Leitungsnetz und die Schaltungseinheiten mit einem additiven Fertigungsverfahren, beispielsweise mit einem 3D-Druck, gefertigt werden.

Unter einem 3D-Druck wird ein Verfahren verstanden, bei dem ein dreidimensionales Objekt durch computergesteuertes schichtweises Auftragen von Material hergestellt wird.

Die Fertigung der Trägerplatte, des Leitungsnetzes und der Schaltungseinheiten mit einem additiven Fertigungsverfahren wie einem 3D-Druck ermöglicht eine flexible, den jeweiligen Anforderungen an die Backplane angepasste Fertigung der Trägerplatte, des Leitungsnetzes und der Schaltungseinheiten.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Backplane mit einem elektrischen Leitungsnetz und daran angeschlossene elektrische Bauelemente, wobei eine erste Menge von Stromwegen durch das Leitungsnetz hervorgehoben ist,
- FIG 2: die in Figur 1 gezeigte Backplane, wobei eine zweite Menge von Stromwegen durch das Leitungsnetz hervorgehoben ist,
- FIG 3: eine perspektivische Darstellung eines Schaltschranks.

Einander entsprechende Teile sind in den Figuren mit denselben Bezugszeichen versehen.

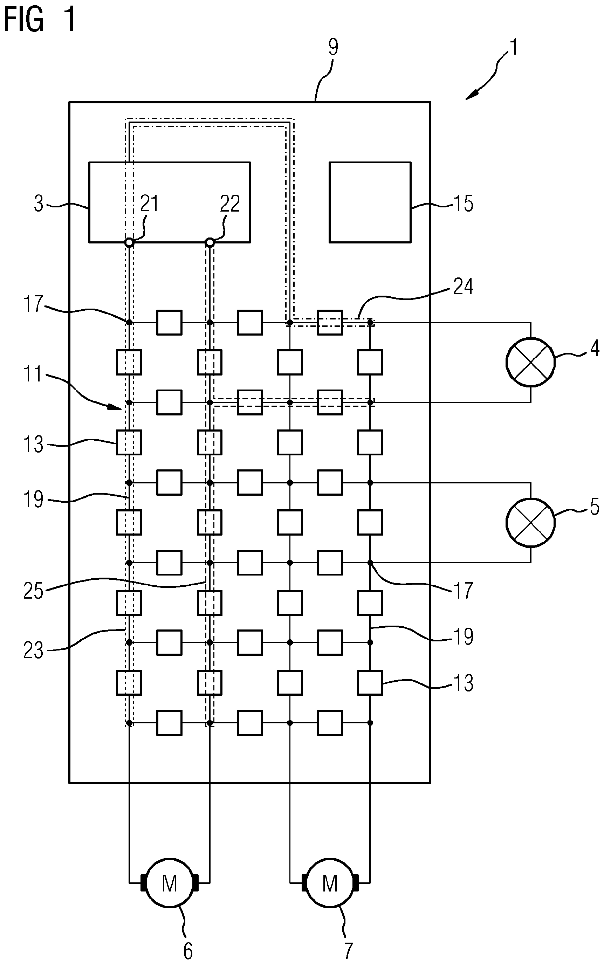

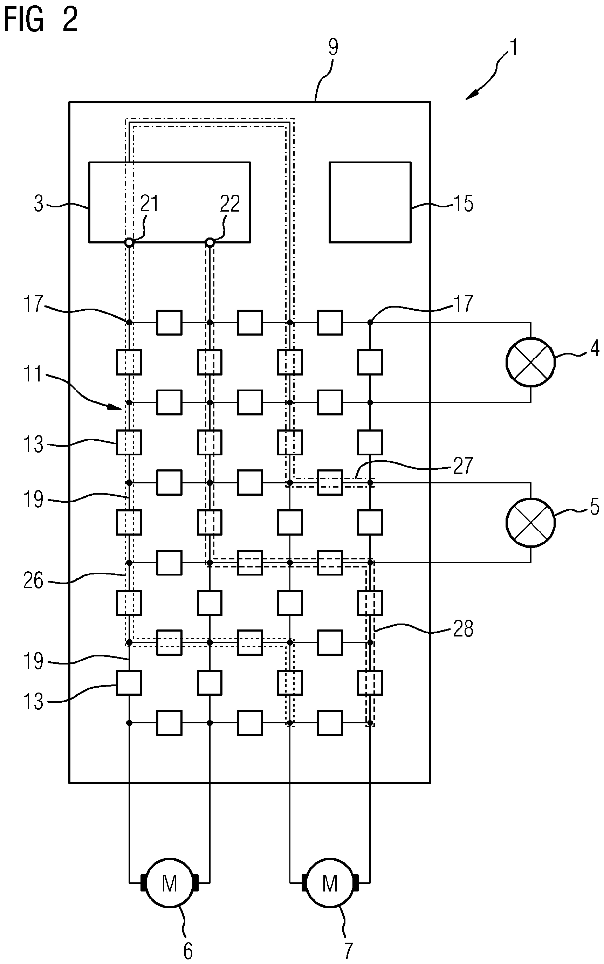

Die Figuren 1 und 2 zeigen jeweils eine Draufsicht auf ein Ausführungsbeispiel einer Backplane 1 zum elektrischen Verbinden elektrischer Bauelemente 3 bis 7. Die Backplane 1 weist eine Trägerplatte 9, ein elektrisches Leitungsnetz 11, Schaltungseinheiten 13 und eine Steuereinheit 15 auf. Die Menge der elektrischen Bauelemente 3 bis 7 umfasst beispielhaft eine Energieversorgungseinheit 3, eine erste Lampe 4, eine zweite Lampe 5, einen ersten Motor 6 und einen zweiten Motor 7. Die Energieversorgungseinheit 3 ist auf der Trägerplatte 9 angeordnet, die Lampen 4, 5 und die Motoren 6, 7 sind neben der Trägerplatte 9 angeordnet.

Das Leitungsnetz 11 ist auf der Trägerplatte 9 angeordnet und weist Netzknoten 17 und jeweils zwei Netzknoten 17 verbindende Verbindungsleitungen 19 auf.

An oder in jeder Verbindungsleitung 19 ist eine Schaltungseinheit 13 angeordnet, die zum steuerbaren Unterbrechen und Freischalten der Verbindungsleitung 19, das heißt zum steuerbaren Öffnen und Schließen einer elektrischen Verbindung der beiden durch die Verbindungsleitung 19 verbundenen Netzknoten 17 ausgebildet ist. Jede Schaltungseinheit 13 ist als ein Mikrosystem ausgebildet.

Die Steuereinheit 15 ist auf der Trägerplatte 9 angeordnet, kann in alternativen Ausführungsbeispielen jedoch auch außerhalb der Trägerplatte 9 angeordnet sein. Mit der Steuereinheit 15 sind die Schaltungseinheiten 13 einzeln ansteuerbar. Beispielsweise sind die Schaltungseinheiten 13 dazu durch (der Übersichtlichkeit halber nicht dargestellte) Steuerleitungen mit der Steuereinheit 15 verbunden. Alternativ oder zusätzlich können die Schaltungseinheiten 13 auch drahtlos, beispielsweise durch Funksignale, mit der Steuereinheit 15 angesteuert werden.

Die Energieversorgungseinheit 3 ist als ein Netzteil mit zwei Versorgungsanschlüssen 21, 22, die jeweils mit dem Leitungsnetz 11 verbunden sind, ausgebildet.

Durch die Schaltungseinheiten 13 können die Netzknoten 17 in verschiedener Weise miteinander elektrisch verbunden werden. Dadurch können verschiedene Stromwege 23 bis 28 in dem Leitungsnetz 11 realisiert werden, um elektrische Bauelemente 3 bis 7 elektrisch zu verbinden.

Figur 1 zeigt die Realisierung dreier Stromwege 23 bis 25 zur Energieversorgung der ersten Lampe 4 und des ersten Motors 6. Ein erster Stromweg 23 verbindet einen ersten Versorgungsanschluss 21 der Energieversorgungseinheit 3 mit einem ersten Motoranschluss des ersten Motors 6. Ein zweiter Stromweg 24 verbindet den ersten Versorgungsanschluss 21 der Energieversorgungseinheit 3 mit einem ersten Lampenanschluss der ersten Lampe 4. Ein dritter Stromweg 25 verbindet den zweiten Versorgungsanschluss 22 der Energieversorgungseinheit 3 mit einem zweiten Motoranschluss des ersten Motors 6 und mit einem zweiten Lampenanschluss der ersten Lampe 4.

Figur 2 zeigt die Realisierung dreier Stromwege 26 bis 28 zur Energieversorgung der zweiten Lampe 5 und des zweiten Motors 7. Ein vierter Stromweg 26 verbindet den ersten Versorgungsanschluss 21 der Energieversorgungseinheit 3 mit einem ersten Motoranschluss des zweiten Motors 7. Ein fünfter Stromweg 27 verbindet den ersten Versorgungsanschluss 21 der Energieversorgungseinheit 3 mit einem ersten Lampenanschluss der zweiten Lampe 5. Ein sechster Stromweg 28 verbindet den zweiten Versorgungsanschluss 22 der Energieversorgungseinheit 3 mit einem zweiten Motoranschluss des zweiten Motors 7 und mit einem zweiten Lampenanschluss der zweiten Lampe 5.

In den Figuren 1 und 2 sind je zwei einander benachbarte Netzknoten 17 jedes Stromwegs 23 bis 28 elektrisch miteinander verbunden, indem die die beiden Netzknoten 17 verbindende Verbindungsleitung 19 durch die an oder in ihr angeordnete Schaltungseinheit 13 geschlossen ist. Alle anderen Verbindungsleitungen 19 des Leitungsnetzes 11 sind durch die jeweils an oder in ihnen angeordneten Schaltungseinheiten 13 unterbrochen.

Die Trägerplatte 9, das Leitungsnetz 11 und die Schaltungseinheiten 13 werden mit einem additiven Fertigungsverfahren, beispielsweise mit einem 3D-Druck, gefertigt. Die Netzknoten 17 und Verbindungsleitungen 19 werden dabei beispielsweise aus einer elektrisch leitfähigen Paste, insbesondere aus einer Kupfer-, Aluminium-, Messing- oder Silberpaste, gedruckt.

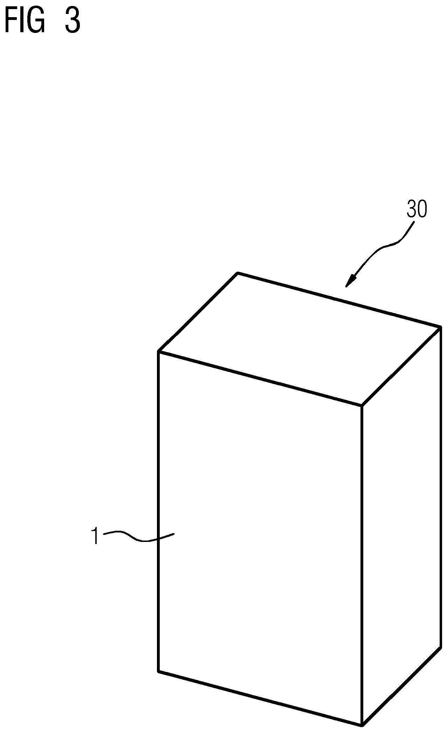

Figur 3 zeigt eine perspektivische Darstellung eines Schaltschranks 30. Der Schaltschrank 30 weist eine wie anhand der Figuren 1 und 2 ausgebildete Backplane 1 auf, die eine Rückwand des Schaltschranks 30 bildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus in den durch die angehängten Ansprüchen vorgegebenen Grenzen abgeleitet werden, ohne den Schutzumfang der Erfindung zu verlassen.

## Patentansprüche

1. Backplane (1) zum elektrischen Verbinden elektrischer Bauelemente (3 bis 7), die Backplane (1) umfassend
- eine Trägerplatte (9),
- ein auf und/oder in der Trägerplatte (9) angeordnetes elektrisches Leitungsnetz (11) zum elektrischen Verbinden der elektrischen Bauelemente (3 bis 7), das Netzknoten (17) und jeweils zwei Netzknoten (17) verbindende Verbindungsleitungen (19) aufweist, und
- ansteuerbare Schaltungseinheiten (13) zum steuerbaren Unterbrechen und Freischalten jeweils einer Verbindungsleitung (19),
**dadurch gekennzeichnet,**
**dass** die Schaltungseinheiten (13) drahtlos ansteuerbar sind.

2. Backplane (1) nach Anspruch 1, wobei wenigstens eine Schaltungseinheit (13) als ein Mikrosystem ausgebildet ist.

3. Backplane (1) nach Anspruch 1, wobei jede Schaltungseinheit (13) als ein Mikrosystem ausgebildet ist.

4. Backplane (1) nach einem der vorhergehenden Ansprüche, wobei an oder in jeder Verbindungsleitung (19) des Leitungsnetzes (11) eine Schaltungseinheit (13) angeordnet ist.

5. Backplane (1) nach einem der vorhergehenden Ansprüche, wobei das Leitungsnetz (11) Steuerleitungen zum Ansteuern der Schaltungseinheiten (13) aufweist.

6. Backplane (1) nach einem der vorhergehenden Ansprüche, wobei die Schaltungseinheiten (13) durch Funksignale ansteuerbar sind.

7. Backplane (1) nach einem der vorhergehenden Ansprüche mit einer Steuereinheit (15) zum Ansteuern der Schaltungseinheiten (13).

8. Schaltschrank (30) mit einer gemäß einem der vorhergehenden Ansprüche ausgebildeten Backplane (1).

## Claims

1. Backplane (1) for electrically connecting electrical components (3 to 7), the backplane (1) comprising
- a carrier plate (9),
- an electrical supply network (11) for electrically connecting the electrical components (3 to 7), which is arranged on and/or in the carrier plate (9) and which has network nodes (17) and connection lines (19) connecting in each case two network nodes (17), and
- actuatable circuit units (13) for controllably interrupting and disconnecting a respective connecting line (19),
**characterized in that**
the circuit units (13) can be actuated wirelessly.

2. Backplane (1) according to Claim 1, wherein at least one circuit unit (13) is designed as a microsystem.

3. Backplane (1) according to Claim 1, wherein each circuit unit (13) is designed as a microsystem.

4. Backplane (1) according to one of the preceding claims, wherein one circuit unit (13) is arranged on or in each connecting line (19) of the supply network (11).

5. Backplane (1) according to one of the preceding claims, wherein the supply network (11) has control lines for actuating the circuit units (13).

6. Backplane (1) according to one of the preceding claims, wherein the circuit units (13) can be actuated by radio signals.

7. Backplane (1) according to one of the preceding claims having a control unit (15) for actuating the circuit units (13) .

8. Switchgear cabinet (30) having a backplane (1) designed according to one of the preceding claims.

## Revendications

1. Fond de panier (1) pour la connexion électrique de composants (3 à 7) électriques, le fond de panier (1) comprenant
- une plaque (9) formant support,
- un réseau (11) de lignes électriques disposé sur et/ou dans la plaque (9) formant support pour la connexion électrique des composants (3 à 7) électriques, qui a des nœuds (17) de réseau et des lignes (19) de connexion connectant respectivement deux nœuds (17) de réseau, et
- des unités (13) de commutation pouvant être commandées afin de commander l'interruption et la connexion respectivement depuis une ligne (19) de connexion,
**caractérisé**
**en ce que** les unités (13) de commutation peuvent être commandées sans fil.

2. Fond de panier (1) suivant la revendication 1, dans lequel au moins une unité (13) de commutation est constituée sous la forme d'un microsystème.

3. Fond de panier (1) suivant la revendication 1, dans lequel chaque unité (13) de commutation est constituée sous la forme d'un microsystème.

4. Fond de panier (1) suivant l'une des revendications précédentes, dans lequel une unité (13) de commutation est montée sur ou dans chaque ligne (19) de connexion du réseau (11) de lignes.

5. Fond de panier (1) suivant l'une des revendications précédentes, dans lequel le réseau (11) de lignes a des lignes de commande pour la commande des unités (13) de commutation.

6. Fond de panier (1) suivant l'une des revendications précédentes, dans lequel les unités (13) de commutation peuvent être commandées par des signaux radio.

7. Fond de panier (1) suivant l'une des revendications précédentes, comprenant une unité (15) de commande pour la commande des unités (13) de commutation.

8. Armoire (30) de distribution ayant un fond de panier (1) constitué suivant l'une des revendications précédentes.
